# DEMANDE DE BREVET EUROPEEN

(11) **EP 0 699 916 A1**
(43) Date de publication de la demande: **06.03.1996**
(21) Numéro de dépôt: 95401978.2
(22) Date de dépôt: 31.08.1995
(51) Int. Cl.: G01R 31/00

(54) **Procédé et dispositif pour tester l'efficacité d'un paratonnerre**

(30) Priorité: 01.09.1994 FR 9410522
(71) Demandeur: ELECTRICITE DE FRANCE Service National, F-75008 Paris (FR)
(72) Inventeur: Query, Jean-Louis, F-69100 Villeurbanne (FR); Seltner, Philippe, F-69150 Decines Charpieu (FR)
(74) Mandataire: Ahner, Francis

(57) **Abrégé**

L'invention concerne un procédé pour vérifier l'efficacité, en un emplacement de mesure donné, d'un paratonnerre comprenant au moins un élément capteur (2) relié à un conducteur électrique (3a ; 3b ; 3c ; 3d) de descente à la terre.

Ce procédé comprend les étapes consistant à :
- envoyer sur ledit conducteur de descente à la terre (3a ; 3b ; 3c ; 3d) un courant au moyen d'un dispositif d'injection (4),
- mesurer le champ magnétique émis par ledit conducteur audit emplacement de mesure, à l'aide d'un dispositif de détection (5) délivrant un signal de mesure dont l'amplitude est représentative dudit champ magnétique,
- comparer l'amplitude dudit signal de mesure à un seuil de référence correspondant à l'amplitude du signal de mesure délivré en un emplacement de référence situé à une distance connue (d) dudit conducteur et se situant dans le champ de protection du paratonnerre, afin d'en déduire, lorsque l'amplitude dudit signal de mesure est supérieure au seuil de référence, que ledit emplacement de mesure se trouve dans le champ de protection du paratonnerre.

## Description

La présente invention concerne la protection contre la foudre, et plus particulièrement un procédé et un dispositif pour déterminer l'efficacité d'un dispositif de protection contre la foudre, encore appelé paratonnerre.

Un paratonnerre comporte au moins un élément capteur (tige métallique, fil conducteur, ...) installé au sommet du bâtiment ou installation à protéger, relié à un conducteur électrique de descente à la terre, ou de préférence relié à un réseau de conducteurs de descente formant une cage de Faraday.

La couverture d'un paratonnerre peut être estimée à partir d'une modélisation de la propagation de la foudre sous la forme de la descente d'une sphère dont le rayon, appelé rayon d'amorçage, dépend de l'intensité de l'éclair. Le premier point du bâtiment ou de l'installation qui vient au contact de cette sphère est celui où la foudre est susceptible de s'abattre. Il faut donc s'assurer que ce point est un élément capteur du paratonnerre ou un conducteur du réseau de descente à la terre. Cette vérification peut s'avérer difficile dans le cas où l'installation ou le bâtiment à protéger présentent une géométrie complexe.

La présente invention a pour objet de proposer un procédé et un dispositif permettant de vérifier d'une façon aisée l'efficacité d'un paratonnerre.

Le procédé selon l'invention, qui vise à déterminer si un emplacement de mesure donné se situe dans le champ de protection d'un paratonnerre, se caractérise en ce qu'il comprend les étapes consistant à :
- envoyer sur un conducteur de descente à la terre du paratonnerre un courant au moyen d'un dispositif d'injection,
- mesurer le champ magnétique émis par ledit conducteur de descente audit emplacement de mesure, à l'aide d'un dispositif de détection délivrant un signal de mesure dont l'amplitude est représentative dudit champ magnétique,
- comparer l'amplitude dudit signal de mesure à un seuil de référence correspondant à l'amplitude du signal de mesure délivré en un emplacement de référence situé à une distance connue dudit conducteur de descente et se trouvant dans le champ de protection du paratonnerre, afin d'en déduire, lorsque l'amplitude dudit signal de mesure est supérieure au seuil de référence, que ledit emplacement de mesure se trouve dans le champ de protection du paratonnerre.

Avantageusement, on mesure à l'aide du dispositif de détection le courant parcourant ledit conducteur de descente à la terre, et on détermine à partir des variations de l'amplitude du courant mesuré les variations du seuil de référence. On peut ainsi n'effectuer qu'un seul étalonnage au début de l'utilisation de l'appareil.

De préférence, le courant est injecté sur ledit conducteur de façon intermittente.

Avantageusement, le courant injecté est un courant basse fréquence, de préférence inférieure à 30 kHz.

Lorsque le paratonnerre comprend au moins un élément capteur relié à au moins deux conducteurs électriques de descente à la terre, le retour du courant au dispositif d'injection s'effectue de préférence avec plusieurs conducteurs de retour de courant reliés à la terre en des emplacements agencés par rapport aux points de mise à la terre desdits conducteurs électriques de descente à la terre de manière à ce que le courant injecté par le dispositif d'injection se répartisse de façon homogène dans les conducteurs de descente à la terre.

L'invention a également pour objet un dispositif pour mettre en oeuvre le procédé précité, comprenant :
. un dispositif d'injection pour envoyer sur un conducteur de descente à la terre un courant,
. un dispositif de détection pour mesurer le champ magnétique émis par ledit conducteur de descente à la terre en un emplacement de mesure donné dont on cherche à savoir s'il est protégé ou non, le dispositif de détection étant apte à délivrer un signal de mesure représentatif dudit champ magnétique, en vue de la comparaison de l'amplitude de ce signal de mesure à un seuil de référence correspondant à l'amplitude du signal de mesure délivré en un emplacement de référence situé à une distance connue du conducteur de descente et se trouvant dans le champ de protection du paratonnerre.

D'autres caractéristiques et avantages de la présente invention apparaîtront à la lecture de la description détaillée qui va suivre, d'un exemple de réalisation non limitatif de l'invention, et à l'examen du dessin annexé sur lequel :
- la figure 1 montre un dispositif d'injection de courant et un dispositif de détection utilisés conformément au procédé selon l'invention,
- les figures 2 et 3 correspondent à deux possibilités d'utilisation d'un dispositif de détection conformément au procédé selon l'invention,
- la figure 4 représente, de façon schématique, un dispositif d'injection conforme à l'invention, et
- la figure 5 représente, de façon schématique, un dispositif de détection conforme à l'invention.

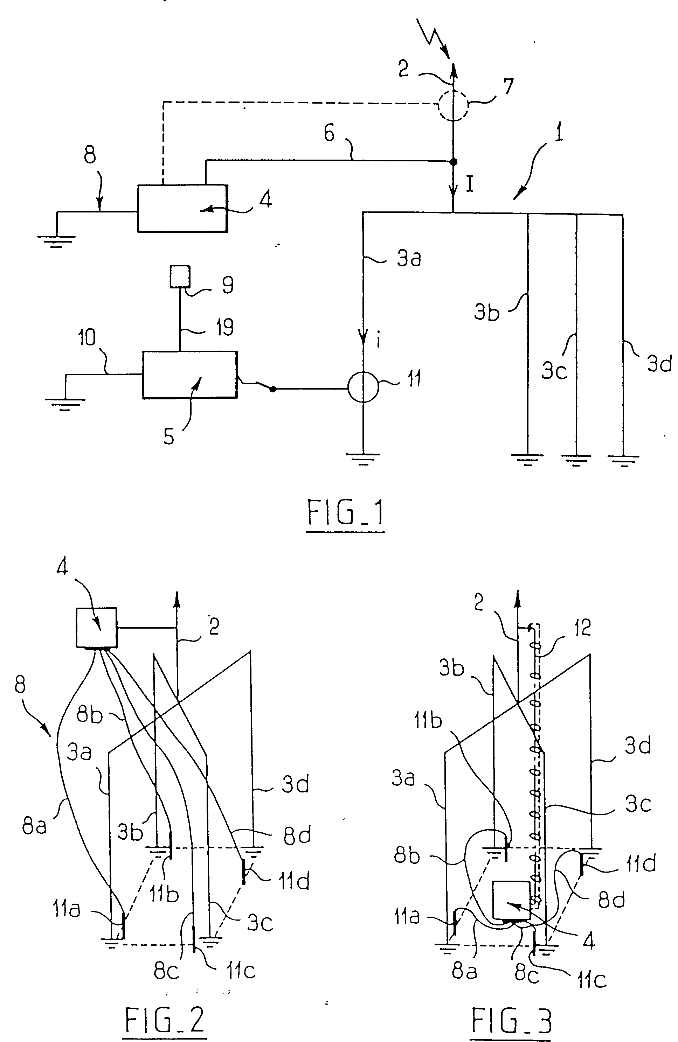

On a représenté sur la figure 1, de façon schématique, un dispositif de protection 1 contre la foudre, comprenant un élément capteur 2 (par exemple tige métallique) à installer au sommet d'un bâtiment ou installation à protéger, relié à un réseau de conducteurs électriques de descente à la terre. Dans l'exemple décrit, I'élément capteur 2 est relié à quatre conducteurs électriques 3a, 3b, 3c et 3d de descente à la terre, s'étendant respectivement le long des façades Nord, Est, Sud et Ouest du bâtiment ou de l'installation, de manière à former une cage de Faraday. La répartition du courant parcourant l'élément capteur 2 dans les conducteurs 3a, 3b, 3c et 3d dépend de l'impédance de ces derniers. Ainsi, lorsque les impédances sont égales, le courant parcourant l'élément capteur 2 se divise en quatre courants égaux dans les conducteurs 3a, 3b, 3c et 3d. Bien entendu, l'invention s'applique quel que soit le nombre des conducteurs électriques du réseau de descente à la terre et la nature de ces derniers (câbles, structures métalliques, ...).

Un courant I est injecté sur l'élément capteur 2 par un dispositif d'injection de courant 4 conforme à l'invention. Un dispositif de détection 5 est utilisé pour mesurer le champ magnétique en un emplacement de mesure donné, afin de savoir si cet emplacement se situe ou non dans le champ de protection du paratonnerre.

L'injection du courant I peut s'effectuer par contact électrique avec l'élément capteur 2 comme représenté sur la figure 1, au moyen d'un câble électrique 6 muni en extrémité d'une pince, ou par induction, au moyen d'une boucle 7 traversée par l'élément capteur 2. Le retour du courant injecté sur l'élément capteur 2 au dispositif d'injection 4 s'effectue par un ou, de préférence plusieurs, câbles électriques 8 reliés à la terre, comme cela sera précisé dans la suite.

La mesure du champ magnétique par le dispositif de détection 5 s'effectue au moyen d'un cadre bobiné 9 ou par tout autre moyen équivalent connu de l'homme du métier (sonde à effet Hall, ...). Le dispositif de détection 5 est relié à la terre par un câble électrique 10. Conformément à une caractéristique avantageuse de l'invention, et comme cela sera précisé dans la suite, le dispositif de détection 5 comporte également des moyens pour mesurer le courant i parcourant un conducteur de descente à la terre, avantageusement une pince ampèremétrique 11 fermée sur ce dernier. En variante, on peut mesurer le courant i au moyen d'un capteur de champ magnétique placé à une distance connue du conducteur électrique, et après un étalonnage préalable.

Le retour du courant au dispositif d'injection 4 peut s'effectuer de plusieurs façons. De préférence, le retour s'effectue par plusieurs câbles de retour reliés chacun à un piquet métallique enfoncé dans le sol. Ces câbles de retour sont disposés de préférence de façon symétrique autour de la verticale passant par le point le plus haut du bâtiment ou installation à protéger, où se situe en principe un élément capteur du paratonnerre. Le but de cette disposition des conducteurs de retour sur le sol est d'assurer la répartition la plus homogène possible du courant qui est envoyé sur l'élément capteur 2 dans les conducteurs de descente.

Dans les exemples des figures 2 et 3, le retour du courant s'effectue par quatre câbles électriques 8a, 8b, 8c et 8d reliés à des piquets 11a, 11b, 11c et 11d respectivement disposés à proximité des points de mise à la terre des conducteurs 3a, 3b, 3c et 3d, de manière à ce que le courant I injecté sur l'élément capteur 2 se divise en quatre courants i égaux, aucun de ces conducteurs de descente n'étant privilégié du fait de la répartition symétrique des câbles de retour.

Dans l'exemple de la figure 2, le dispositif d'injection 4 est installé au sommet du bâtiment ou de l'installation équipé du paratonnerre dont on cherche à tester l'efficacité. Les quatre câbles de retour 8a, 8b, 8c et 8d sont reliés ensemble à une extrémité au dispositif d'injection 4 et à l'autre extrémité à la terre par les piquets de mise à la terre 11a, 11b, 11c et 11d.

En variante, comme représenté sur la figure 3, le dispositif d'injection 4 est laissé au niveau du sol et le courant à envoyer sur le paratonnerre est acheminé vers l'élément capteur 2 par un conducteur coaxial 12 relié au dispositif d'injection 4. La solution correspondant à la figure 3 est préférable, car elle permet d'éviter le transport du dispositif d'injection 4 au sommet du bâtiment ou de l'installation à examiner et la mise en place des câbles de retour 8a, 8b, 8c et 8d est aisée.

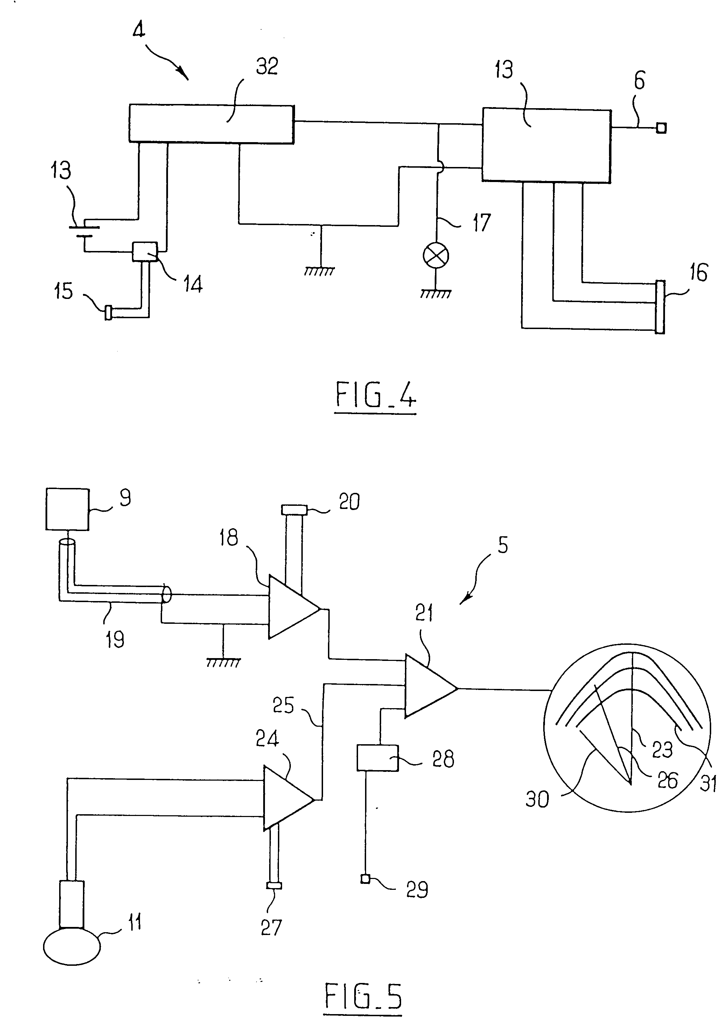

On a représenté sur la figure 4, de façon schématique, un exemple de réalisation de dispositif d'injection 4 conforme à l'invention. De préférence, le courant est injecté de façon intermittente, les temps morts d'émission étant mis à profit pour s'assurer, en fonction du rapport signal / bruit, que le champ magnétique détecté est seulement celui dû au courant injecté. L'émission du courant peut, par exemple, s'effectuer par cycles de 30 secondes d'émission consécutive, séparés par des temps morts de 10 secondes. Dans la réalisation de la figure 4, le dispositif d'injection comporte un oscillateur 32 alimenté par une source d'énergie électrique 13 disposée en série avec un cadenceur 14 dont on peut régler la cadence de fermeture par des moyens de réglage 15. L'oscillateur 32 est ainsi alimenté de façon intermittente, pour générer des cycles d'émission continue séparés par des temps morts d'émission. Le signal délivré par l'oscillateur 32 est amplifié par l'amplificateur 13. On a indiqué par la référence 16, de façon schématique, des moyens de réglage du gain de l'amplificateur 13, donc de l'intensité du courant envoyé sur le paratonnerre.

L'oscillateur 32 comporte dans l'exemple décrit un élément piézoélectrique délivrant des impulsions dont la forme est proche de celle du courant de foudre. Un voyant 17 indiquant l'envoi d'une impulsion est placé à la sortie de l'oscillateur 32. En variante, le courant injecté peut être un courant sinusoïdal basse fréquence ou une suite de courant de fréquences différentes (100 Hz, 1 kHz, 10 kHz, 20 kHz, ...) celles-ci restant de préférence inférieures à 30 kHz. Le signal délivré en sortie de l'amplificateur 13 est envoyé sur le paratonnerre, soit directement au moyen du câble 6 comme dans le cas de la figure 1, soit par induction au moyen de la boucle 7.

En variante, le cadenceur 14 et l'oscillateur 32 sont remplacés par un enregistreur numérique, par exemple du type connu sous la référence ISD 1016 AB. Un signal est mis en mémoire (du type impulsionnel, sinusoïdal ou autre, ...) dans l'enregistreur, puis ce signal est lu de façon répétée par l'enregistreur lorsque le dispositif d'injection est utilisé.

On a représenté sur la figure 5, de façon schématique, le dispositif de détection 5. Ce dispositif comporte un premier amplificateur 18 recevant en entrée le signal recueilli par le cadre bobiné 9 et acheminé à l'amplificateur 18 par un câble coaxial 19. On a indiqué par la référence 20 des moyens de réglage du gain de l'amplificateur 18. Le signal délivré en sortie de l'amplificateur 18 est amplifié à nouveau par des moyens d'amplification 21 pour alimenter un galvanomètre dont l'aiguille 23 indique par sa position l'amplitude du flux magnétique traversant le cadre bobiné 9. L'aiguille 23 se déplace avantageusement en regard d'une échelle graduée en pourcentages.

Avantageusement, comme représenté sur les figures 1 et 5, le dispositif de détection 5 comporte également des moyens pour mesurer l'amplitude du courant parcourant un conducteur de descente. Cette mesure locale de l'intensité s'effectue par induction au moyen de la pince ampèremétrique 11, reliée à un amplificateur 24 muni de moyens de réglage 27 du gain. L'amplificateur 24 est relié en sortie en 25 aux moyens d'amplification 21 pour alimenter un galvanomètre dont l'aiguille 26 indique l'amplitude du courant. La mesure de l'intensité du courant parcourant les conducteurs de descente à la terre permet d'une part de détecter un défaut de mise à la terre d'un conducteur de descente, et permet d'autre part d'éviter d'effectuer un nouvel étalonnage du dispositif de détection 4 lorsque l'amplitude du courant dans le conducteur de descente engendrant le champ magnétique mesuré par le cadre bobiné 9 varie, comme cela sera précisé dans la suite.

L'atteinte du paratonnerre par la foudre peut se modéliser par la descente d'une sphère dont le rayon est fonction de l'intensité de l'éclair. Ce rayon peut s'exprimer, selon un modèle connu, par la formule R = 10.I_{Eclair}2/3 (R en mètres, I_{Eclair} en kA). Le dispositif de détection 5 incorpore, de façon facultative, un générateur de courant 28 et des moyens de réglage 29 de l'intensité délivrée par ce générateur 28, constitués par exemple par un potentiomètre dont le curseur est monté à déplacement en regard d'une échelle graduée en intensités de courant de foudre I_{Eclair}. Le générateur 28 délivre un courant représentatif du rayon R correspondant au courant de foudre I_{Eclair} sélectionné par le potentiomètre, en vue de son affichage par une aiguille 30 d'un galvanomètre se déplaçant en regard d'une échelle 31 graduée en mètres. On peut bien entendu remplacer le générateur 28, les moyens de réglage 29 et le galvanomètre associé par un simple abaque.

L'utilisation du dispositif d'injection 4 et du dispositif de détection 5, conformément au procédé selon l'invention, est la suivante.

Le dispositif d'injection 4 est installé, soit sur le bâtiment, soit laissé au niveau du sol, l'alimentation du paratonnerre s'effectuant alors par un câble coaxial 12 comme représenté sur la figure 3. Un courant I est injecté de façon intermittente sur l'élément capteur 2. Ce courant I se divise en des courants i, en principe d'amplitudes égales si les conducteurs de descente à la terre 3a, 3b, 3c et 3d ne sont pas endommagés et si les piquets 11a, 11b, 11c et 11d de connexion à la terre reliés aux câbles de retour 8a, 8b, 8c et 8d sont positionnés de façon adéquate. Le dispositif de détection 5 est ensuite placé pour son étalonnage à une distance connue d de l'élément capteur 2 ou d'un conducteur de descente 3a, 3b, 3c et 3d du paratonnerre. On vérifie que cette distance d est inférieure au rayon d'amorçage R pour un éclair d'intensité I_{Eclair} donnée en s'aidant, si nécessaire, du générateur 28 ou de tout abaque équivalent. Après s'être assuré qu'à la distance d du conducteur sélectionné on se situe bien dans le champ de protection du paratonnerre, on mesure à cette distance d le champ magnétique ainsi que le courant parcourant le conducteur. On agit sur les moyens de réglage de gain 20 et 27 de manière à obtenir un positionnement des aiguilles 23 et 26 chacune devant une graduation de référence, par exemple la graduation "100 %". Ensuite, en baladant le cadre 9 à un même étage du bâtiment ou à la même altitude on s'assure que l'ensemble des matériels à protéger se situe dans le champ de protection du paratonnerre, en vérifiant qu'en tout point de mesure le champ magnétique reste supérieur au seuil de référence. On peut avantageusement effectuer des mesures selon les noeuds d'un maillage régulier. Dans le cas de l'utilisation du dispositif d'injection conformément à la figure 2, on peut, en cas de perturbations dues aux câbles de retour 8a, 8b, 8c et 8d, utiliser pour ces derniers des câbles coaxiaux. On a constaté en pratique qu'il suffisait de débrancher le câble de retour le plus proche du cadre bobiné 9 pour supprimer la perturbation provoquée par le courant de retour parcourant ce câble. Les essais ont montré qu'alors, le courant injecté se répartissait encore de façon suffisamment homogène dans les trois conducteurs de descente à la terre choisis parmi les conducteurs 3a, 3b, 3c, 3d.

Si en déplaçant le cadre bobiné 9 à un même étage ou altitude, on constate qu'en un emplacement particulier le champ mesuré descend en dessous du seuil de référence, cela signifie que cet emplacement est insuffisamment protégé par le paratonnerre. Dans la pratique, la distance de référence d est prise égale à quelques mètres et l'on décide que l'emplacement de mesure est insuffisamment protégé lorsque le champ mesuré devient inférieur à la moitié de la valeur du champ à la distance de référence. La mesure de l'amplitude du courant parcourant les conducteurs de descente 3a, 3b, 3c et 3d permet de vérifier l'absence de défaut de conduction dans ces derniers. Elle permet également (lorsque l'on change d'altitude ou d'étage et que l'intensité parcourant le conducteur de descente qui engendre le champ magnétique qui est mesuré par le cadre bobiné 9 a varié, par exemple parce que le courant s'est divisé dans plusieurs branches) d'éviter d'avoir à procéder à un nouvel étalonnage du détecteur en se plaçant à une distance connue. Il suffit de modifier la valeur du seuil de référence dans une même proportion que la variation relative du courant mesuré. Ainsi, lorsque par exemple l'intensité parcourant l'élément capteur 2 et mesuré par la pince ampèremétrique 11 vaut I au sommet du bâtiment, et que le courant a été divisé par un facteur 4 dans les branches 3a, 3b, 3c et 3d aux étages inférieurs, l'amplitude du champ magnétique à la distance d de chaque conducteur 3a, 3b, 3c et 3d devient quatre fois moindre que le champ magnétique à la distance d de l'élément capteur 2. Par conséquent, si le réglage du gain des amplificateurs 18 et 24 a été effectué au sommet de l'installation, il suffit de quadrupler le gain de l'amplificateur 18 aux étages inférieurs pour conserver la même indication de référence "100 %" donnée par l'aiguille 23 à la distance d de chaque conducteur 3a, 3b, 3c et 3d aux étages inférieurs.

L'invention n'est pas limitée aux exemples de réalisation qui viennent d'être décrits. On peut effectuer le réglage du gain de l'amplificateur 18 de façon automatique en fonction de l'intensité mesurée sur le conducteur électrique de descente qui engendre le champ magnétique mesuré par le dispositif de détection 5. On peut également utiliser, à la place d'une pince ampèremétrique 11, tout bobinage magnétique, traversé ou non par le conducteur électrique de descente, placé à proximité de ce dernier. On peut encore remplacer les galvanomètres précités par tout indicateur connu de l'homme du métier (afficheur numérique ou autre ...).

## Revendications

**1/** Procédé pour vérifier l'efficacité, en un emplacement de mesure donné, d'un paratonnerre comprenant au moins un élément capteur (2) relié à un conducteur électrique (3a ; 3b ; 3c ; 3d) de descente à la terre, caractérisé en ce qu'il comprend les étapes consistant à :
- envoyer sur ledit conducteur de descente à la terre (3a ; 3b ; 3c ; 3d) un courant au moyen d'un dispositif d'injection (4),
- mesurer le champ magnétique émis par ledit conducteur de descente audit emplacement de mesure, à l'aide d'un dispositif de détection (5) délivrant un signal de mesure dont l'amplitude est représentative dudit champ magnétique,
- comparer l'amplitude dudit signal de mesure à un seuil de référence correspondant à l'amplitude du signal de mesure délivré en un emplacement de référence situé à une distance connue (d) dudit conducteur de descente à la terre et se situant dans le champ de protection du paratonnerre, afin d'en déduire, lorsque l'amplitude dudit signal de mesure est supérieure au seuil de référence, que ledit emplacement de mesure se trouve dans le champ de protection du paratonnerre.

**2/** Procédé selon la revendication 1, caractérisé en ce que l'on mesure à l'aide du dispositif de détection (4) le courant parcourant ledit conducteur de descente, et en ce que l'on détermine à partir des variations de l'amplitude du courant mesuré les variations du seuil de référence.

**3/** Procédé selon l'une des revendications 1 et 2, caractérisé en ce que le courant est injecté sur ledit conducteur de façon intermittente.

**4/** Procédé selon la revendication 3, caractérisé en ce que le courant injecté est un courant basse fréquence, de préférence inférieure à 30 kHz.

**5/** Procédé selon l'une des revendications 1 à 4, le paratonnerre comprenant au moins un élément capteur relié à au moins deux conducteurs électriques de descente à la terre (3a ; 3b ; 3c ; 3d), caractérisé en ce que le retour du courant injecté au dispositif d'injection (4) s'effectue avec plusieurs conducteurs de retour de courant (8a ; 8b ; 8c ; 8d), ces derniers étant reliés à la terre en des emplacements agencés par rapport aux points de mise à la terre desdits conducteurs électriques de descente à la terre de manière à ce que le courant injecté se répartisse de façon homogène dans lesdits conducteurs de descente à la terre.

**6/** Dispositif pour vérifier l'efficacité, en un emplacement de mesure donné, d'un paratonnerre, ce dernier comprenant au moins un élément capteur (2) relié à un conducteur électrique de descente à la terre (3a ; 3b ; 3c ; 3d), caractérisé en ce qu'il comprend :
. un dispositif d'injection pour injecter sur un conducteur de descente à la terre un courant,
. un dispositif de détection pour mesurer le champ magnétique émis par ledit conducteur de descente à la terre en un emplacement de mesure donné dont on cherche à savoir s'il est protégé ou non, le dispositif de détection étant apte à délivrer un signal de mesure représentatif dudit champ magnétique, en vue de la comparaison de l'amplitude de ce signal de mesure à un seuil de référence correspondant à l'amplitude du signal de mesure délivré en un emplacement de référence situé à une distance connue dudit conducteur de descente à la terre et se trouvant dans le champ de protection du paratonnerre.

**7/** Dispositif selon la revendication 6, caractérisé en ce qu'il comprend en outre des moyens pour mesurer le courant parcourant ledit conducteur de descente à la terre.

**8/** Dispositif selon la revendication 7, caractérisé en ce que l'oscillateur (32) comporte un élément piézoélectrique délivrant des impulsions dont la forme est proche de celles dues à la foudre.
